(19) Europäisches Patentamt
European Patent Office
Office européen des brevets

(11) Publication number: **0 214 307 B1**

(12) # EUROPEAN PATENT SPECIFICATION

(45) Date of publication of patent specification: **17.07.91 Bulletin 91/29**

(51) Int. Cl.[5]: **H01L 23/48**, H01L 21/60

(21) Application number: **86901518.0**

(22) Date of filing: **28.02.86**

(86) International application number: **PCT/JP86/00106**

(87) International publication number: **WO 86/05322 12.09.86 Gazette 86/20**

(54) **SEMICONDUCTEUR CIRCUIT DEVICE.**

(30) Priority: **28.02.85 JP 28544/85**
**11.07.85 JP 105747/85**
**17.02.86 JP 21361/86**

(43) Date of publication of application: **18.03.87 Bulletin 87/12**

(45) Publication of the grant of the patent: **17.07.91 Bulletin 91/29**

(84) Designated Contracting States: **DE FR GB NL**

(56) References cited:
**EP-A- 0 090 503**
**FR-A- 2 550 661**
**JP-A- 5 735 361**
**JP-A- 5 793 559**
**JP-A- 5 910 249**
**JP-A-57 117 265**
**JP-U- 5 465 666**

(56) References cited:
**JP-U-55 108 745**
**JP-U-59 128 736**
**PATENT ABSTRACTS OF JAPAN, vol. 7, no. 4 (E-151)[1149] 8th January 1983; & JP-A-57 164 548 (**
**Idem**

(73) Proprietor: **SONY CORPORATION**
**7-35 Kitashinagawa 6-Chome Shinagawa-ku**
**Tokyo 141 (JP)**

(72) Inventor: **WATANABE, Kazuo Sony Corporation**
**7-35, Kitashinagawa 6-chome Shinagawa-ku**
**Tokyo 141 (JP)**
Inventor: **ARAKI, Shigeo Sony Corporation**
**7-35, Kitashinagawa 6-chome Shinagawa-ku**
**Tokyo 141 (JP)**

(74) Representative: **TER MEER - MÜLLER - STEINMEISTER & PARTNER**
**Mauerkircherstrasse 45**
**W-8000 München 80 (DE)**

**EP 0 214 307 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to improvements of a semiconductor circuit device.

BACKGROUND ART

Referring initially to Fig. 7, the construction of a prior art semiconductor integrated circuit device (IC) will be described.

In Fig. 7, reference numeral 1 denotes a semiconductor circuit element (chip). A number of terminals 2 (2a, 2b,... 2i,... 2p, 2u,...) are provided on the peripheral edge portion of the upper surface thereof. A predetermined signal current is supplied through the terminals 2 to the circuit mounted on the chip 1 and an output signal is derived therefrom. Further, a predetermined power is supplied through the power source terminal 2s to the circuit and the ground terminal 2g is connected to an external reference potential point (earth).

Reference numeral 3 designates a die bonding pad which is formed as one portion of a lead frame (not shown) made of a thin metal plate such as Kovar and the like and which is supported on the frame portion of the lead frame by a pair of support bars 4 and 5. The chip 1 is mounted on the die bonding pad 3 and bonded thereto by a silver paste or the like. The respective terminals 2a, 2b,... 2i, 2p,... 2u of the chip 1 and corresponding leads 6 (6a, 6b,... 6i, 6p,... 6u,...) of the lead frame are respectively interconnected via gold wires w each having a diameter of about 20 μm. Then, after the whole thereof is molded by a synthetic resin in order to become a package 7 of a DIL (Dual In Line) type as shown by a one dot chain line, the outside portion of the lead frame is cut off. At that time, the tips of the respective leads of the package 7 are bent to form pins which are used to mount the IC on the printed circuit board or the like. Reference numeral 8 designates a concave portion of the package 7 which indicates the direction in which the pins are aligned.

By the way, in the conventional IC, particularly in the multi-purpose IC such as a memory, a TTL (Transistor-to-Transistor Logic) and so on, one of the leads located most-closely to the concave portion 8 which indicates the direction of the pin alignment, that is, the lead 6s located at the left end of the upper row in Fig. 7 is connected to an external power source. While, one of the leads located most-remotely from the concave portion 8 so as to become substantially dot-symmetrical to the lead 6s with respect to the chip 1, that is, the lead 6g in the right end of the lower row in the same figure is connected to an external earth. As will be clear from Fig. 7, both the leads 6g and 6s are adjoining to the support bars 4 and 5, respectively and they belong to the longest lead groups including the gold wire w.

Therefore, both the leads 6g and 6s become relatively large in inductance. Hence, when the electronic circuit mounted on the chip 1 is required to operate at high speed and with large current, transient noise voltages are produced on both the leads, that is, the power source lead 6s and the ground lead 6g on the basis of the impedances thereof. There then arise defects that the electrical property of the circuit will be deteriorated and that the circuit will mal-function.

When the chip 1 is a semiconductor memory, if the inductances of both the leads 6g and 6s are taken as $L\ell$, respectively and a charge (or discharge) current having a peak value $I_p$ is flowed between an output buffer amplifier having n ports mounted and an external passive load (all of them are not shown) during a data transition period $2\Delta t$, the induced voltage $e\ell$ on each lead is expressed by the following Eq. (1)

$$e\ell = \frac{di}{dt} \doteqdot \frac{L\ell}{2} \cdot n\frac{IP}{\Delta t} \quad (1)$$

For example, if they are selected as $L\ell$ = 10nH, n = 8, $2\Delta t$ = 8nS and $I_p$ = 50 mA, the voltage $e\ell$ induced on the leads becomes about 0.5 Volts. When the transition period $2\Delta t$ is reduced to 4nS for high speed data processing, if other various conditions are the same, the voltage $e\ell$ induced in both the leads 6g and 6s becomes about 1 Volt.

By the way, in most cases, the level of the signal interchanged between various kinds of digital circuits is selected as a TTL level. When the power source voltage is 5 Volts, "Hi" level is determined as 2.2 Volts and "Lo" level is determined as 0.6 Volts. However, as the circuit is operated at higher speed and with a larger current, the induced voltage $e\ell$ in the above mentioned ground and power source leads becomes as high as this TTL level, causing the digital circuit to mal-function. Since the TTL level is set lower than 1/2 the power source voltage as described above, the influence by the ground lead 6g is large. Whereas, when the digital circuit in operated at high speed, the influence by the power source lead 6s can not be neglected, too.

Further, when a circuit such as a read amplifier (sense amplifier) which handles a very small signal and a circuit such as an output buffer amplifier throughout which a large transient current is flowed are mounted on the single chip, the power source lead 6s and the ground lead 6a become the common inductance to both the circuits. This makes the above mentioned defects more serious.

A semiconductor circuit device comprising in a package the following element is known from EP-A 0 090 503 :

- a semiconducting circuit element having a plurality of terminals ;
- a mount member made of a conductive thin plate material on which said semiconductor circuit element is mounted ;

– a pair of support bars extending from said mount member ;

– and a plurality of lead members to be connected with said plurality of terminals through fine conductive wires.

Furthermore, it is known from JP-A-57 164 548 to use two ground lead members to contact two ground terminals of the semiconductor circuit element. The both ground lead members have a common base portion at their ends opposite to the semiconductor circuit element, said base portion being very small. By this constitution, the noise level can be considerably reduced compared to a device having only a single ground lead.

## DISCLOSURE OF INVENTION

In view of such aspect, an object of the present invention is to provide a semiconductor circuit device which can reduce the common inductance of the power source lead and the ground lead considerably.

The semiconductor circuit device according to the present invention comprises in a package :

– a semiconductor circuit element comprising a small signal circuit system and a large amplitude transient current system, said element having a separate ground terminal for each of said both systems, at least one power source terminal, and a plurality of other terminals ;

– a mount member made of a conductive thin plate material on which said semiconductor circuit element is mounted ;

– a pair of support bars extending from said mount member ;

– and a plurality of lead members to be connected with the plurality of terminals through fine conductive wires, said lead members comprising two ground lead members, one for each of said both ground terminals.

In the device of the present invention, the semiconductor circuit element is divided into two systems, i.e. the small signal circuit system and the large amplitude transient current system, which both systems are grounded via separate terminals and separate lead members, thereby improving the electrical characteristic.

## BRIEF DESCRIPTION OF DRAWINGS

Figs. 1, 2, 4 and 5 are plan views illustrating embodiments of the semiconductor circuit device according to the present invention, Figs. 3 and 6 are schematic cross-sectional views of the semiconductor circuit elements according to the embodiments of the invention and Fig. 7 is a plan view showing an example of a construction of a prior art semiconductor circuit device.

## BEST MODE FOR CARRYING OUT THE INVENTION

Referring to Fig. 1, an embodiment of a semiconductor circuit device according to the present invention will be described hereinafter. In Fig. 1, like parts corresponding to those of Fig. 7 are marked with the same references and the overlapping explanation will be omitted.

In Fig. 1, reference numeral 11 designates a chip (semiconductor circuit element) on which a very small signal circuit system and a large amplitude transient current circuit system are mounted. In correspondence therewith, a ground terminal 2x is newly provided adjacent to the ground terminal 2g and a power source terminal 2z is newly provided adjacent to the power source terminal 2s. Then, the old ground terminal 2g and the new power source terminal 2z are connected to one circuit system, while the new ground terminal 2x and the old power source terminal 2s are connected to the other circuit system. Considering the fact that the two ground terminals 2x and 2g are provided on the chip 11, two leads 6x and 6y are newly provided adjacent to the support bar 14. As illustrated in the figure, both the leads 6x and 6y are coupled together at the peripheral edge portion of the package 7, forming a ground lead 16 having two branches. In this case, the length of a base portion 16c of the ground lead 16 is made as short as possible.

A die bonding pad 13 on which the chip 11 is mounted is supported by a pair of support bars 14 and 15. In connection with the provision of the above mentioned new ground leads 6x and 6y, the support bar 14 occupies a position a little different from that of the prior art support bar 4.

While, the support bar 15 is formed wide in width so as to cover the prior art support bar 5 and power source lead 6s. From the end portion of this support bar 15, there is extended a branch 15s at the same position as that of the prior art power source lead 6s and which is used as a power source lead 15Z serving as the support bar.

The new and old power source terminals 2z and 2s on the chip 11 are each interconnected to the broad power source lead 15Z at its base portion near the die bonding pad 13 via the gold wires (fine conductive wires) w. Whereas, the new and old ground terminals 2x and 2g are each interconnected to the tips of two branches 16x and 16y of the ground lead 16 via the gold wires w. Other portions are constructed similarly to those of the prior art semiconductor circuit device previously described in connection with Fig. 2.

According to the thus made arrangement, with respect to the small signal circuit system and the large current circuit system mounted on the chip, the common inductance at the power source side within the package can be reduced substantially to the half and the common inductance at the ground side can be reduced considerably so that the electrical characteristic can be improved. Hence, the risk of the mal-function can be removed.

Furthermore, since the heat generated in the chip 11 is radiated to the outside through the power source lead 15Z, the temperature at the chip 11 can be suppressed from being raised.

Subsequently, a second embodiment of the semiconductor circuit device according to the present invention will be described with reference to Figs. 2 and 3.

In Fig. 2, like parts corresponding to those of Fig. 7 are marked with the same references and the overlapping explanation will not be made.

In Fig. 2, reference numeral 11 designates the chip (semiconductor circuit element) on which the small signal circuit system and the large amplitude transient current circuit system are mounted. In correspondence therewith, the ground terminal 2x is newly provided adjacent to the ground terminal 2g. Then, the old ground terminal 2g is connected to one circuit system, while the new ground terminal 2x is connected to the other circuit system. Reference numeral 13 designates the ground lead which is so formed that the support bar 14 and a lead 16 adjacent thereto are coupled together at the peripheral edge portion of the package 7 by a coupling portion 17 so as to have two branches. A base portion 18 of the ground lead 13 is reduced in length as much as possible. The die bonding pad 3 on which the chip 11 is mounted is supported by the pair of support bars 15 and 14.

The new ground terminal 2x on the chip 11 is connected to the base portion of the support bar 14 which is one of the branches of the ground lead 13 and near the side of the die bonding pad 3 through the gold wire (fine conductive wire) w. Whereas, the old ground terminal 2g is connected to the tip of the other branch of the ground lead 13 via the gold wire w.

In the chip 11, as shown in Fig. 3, N-type impurity diffusion regions 112 and 113 are formed on the surface of a P-type silicon substrate 111 and a silicon dioxide film 114 is formed thereon, thus forming a number of N-channel MOS FETs 11N. P-type impurity diffusion regions 116 and 117 are formed on the surface of an N well region 115 of the substrate 111 and a silicon dioxide film 118 is formed thereon, thus forming a number of P-channel MOS FETs 11P. When the chip 11 is constructed as described above, the P-type silicon, substrate 111 is set as the earth potential. Accordingly, if the support bar 14 supporting the die bonding pad 3 is used as the branch of the ground lead 13 as shown in Fig. 2, there arises no defect.

Other portions are constructed similarly to those of the prior art device earlier described in connection with Fig. 3.

Then, a third embodiment of the semiconductor circuit device according to the present invention will be described with reference to Figs. 4 to 6.

In Figs. 4 and 5, like parts corresponding to those of Fig. 7 are marked with the same references and the overlapping explanation will not be made.

In Figs. 4 and 5, reference numeral 11 designates the chip (semiconductor circuit element) on which the small signal circuit system and the large amplitude transient current circuit system (both are not shown) are mounted. In correspondence therewith, the new ground terminal 2x is provided adjacent to the ground terminal 2g, while a power source terminal 2y is newly provided adjacent to the power source terminal 2s. The old ground terminal 2g and the old power source terminal 2s are connected to the large current circuit system, while the new ground terminal 2x and the new power source terminal 2y are connected to the small signal circuit system. Bent narrow branches 14 and 15 are respectively extending from the die bonding pad 13 in the left-hand and right-hand directions. One bent narrow branch 14 and the power source lead 16s are coupled together at the peripheral edge portion of the package 7 via a coupling portion 17. Two ground leads 16g and 16x are provided in adjacent relation to the other bent narrow branch 15. Both of the leads 16g and 16x are coupled together at the peripheral edge portion of the package 7 by a coupling portion 18.

The power source terminal 2y and the ground terminal 2x of the small signal circuit system on the chip 11 are connected to one bent narrow branch 14 and to one ground lead 16x through gold wires (fine conductive wires) w. Further, the power source terminal 2s and the ground terminal 2g of the large amplitude transient current circuit system are connected to the tip ends of the power source lead 16s and the other ground lead 16g through the gold wires w.

In the chip 11, as shown in Fig. 6, on the surface of the N-type silicon substrate 111, the P-type impurity diffusion layers 112 and 113 are formed and the silicon dioxide film 114 is also formed, thus forming a large number of P-channel MOS PETs 11P. Further, on the surface of the P well region 115 of the substrate 111, the N-type impurity diffusion layers 116 and 117 are formed and the silicon dioxide film 118 is also formed, forming a large number of N-channel MOS FETs 11N. When the chip 11 is constructed as described above, the N-type silicon substrate 111 is set as a power source potential. Accordingly, if the bent member 14 extended from the die bonding pad 3 is connected to the power source lead 16s as shown in Fig. 5, there will arise no trouble.

Other portions are constructed similarly to those of the prior art device previously described in connection with Fig. 7.

While in the above mentioned embodiment one bent member is used as the power source lead, it is possible to use a plurality of leads as the power source lead similarly to the ground lead.

According to the above mentioned arrangement, for the small signal circuit system and the large current circuit system mounted on the chip, the common inductance of the power source side and the ground side within the package can be reduced considerably and the mutual action between both the circuit systems can be reduced very much so that the electrical characteristic can be improved and hence the fear of mal-function will be removed.

While in the above mentioned embodiments the semiconductor chip is incorporated in the package made of plastics material, it is needless to say, in the case where the semiconductor chip is incorporated in the package made of ceramics, that the same action and effect can be achieved.

## Claims

1. A semiconductor circuit device comprising in a package (7):
– a semiconducting circuit element (11) having a plurality of terminals (2a... 2z);
– a mount member (13) made of a conductive thin plate material on which said semiconductor circuit element is mounted;
– a pair of support bars (14, 15) extending from said mount member;
– and a plurality of lead members (6a... 6y, 16) to be connected with said plurality of terminals through fine conductive wires (w);
**characterized in that**
– said semiconductor circuit element comprises a small signal circuit system and a large amplitude transient current system with a separate ground terminal (2g, 2x) for each of said both systems,
– and two ground lead member (6x, 6y; 14, 16; 16g, 16x) are provided, one for each of said both ground terminals, which two lead members have a common base portion (16c, 18) at their ends opposite to the semiconductor circuit element, said base portion being as short as possible.

2. A device according to claim 1, **characterized in that** said semiconductor circuit element (11) is formed of a P-type silicon substrate (111) and one of said support bars (14) is used as one of said two ground lead members.

3. A device according to claim 1 or claim 2, **characterized in that** two power source terminals (2s, 2z; 2s, 2y) are provided, one for said small signal circuit system, and the other one for said large amplitude transient current system.

4. A device according to claim 3, **characterized in that** two power source lead members (16s, 14) are provided, one for each of said both power source terminals (2s, 2z; 2s, 2y).

## Patentansprüche

1. Gekapselter (7) Halbleiterschaltkreis mit:
– einem Halbleiterschaltkreiselement (11) mit einer Mehrzahl von Anschlüssen (2a,..., 2z);
– einem Montageteil (13) aus einem dünnen leitenden Plattenmaterial, auf welchem das Halbleiterschaltkreiselement gehalten ist;
– einem Paar von Stützstreifen (14, 15), die sich von dem Montageteil aus erstrecken; und mit
– einer Mehrzahl von Anschlußteilen (6a,..., 6y, 16), die über feine leitende Drähte (w) mit der Mehrzahl von Anschlüssen verbunden sind;
**dadurch gekennzeichnet,** daß
– das Halbleiterschaltkreiselement ein System mit kleinen Signalen und ein System mit Transient-Strömen großer Amplitude aufweist, mit einem separaten Masseanschluß (2g, 2x) für jedes der beiden Systeme, und
– zwei Masseanschlußteile (6x, 6y; 14, 16; 16g, 16x) vorgesehen sind, jeweils eines für die beiden Masseanschlüsse, wobei den beiden Masseanschlußteilen ein gemeinsamer Basisabschnitt (16c, 18) an ihren dem Halbleiterschaltkreiselement entgegengesetzten Enden zugeordnet ist, welcher Basisabschnitt so kurz als möglich ausgeführt ist.

2. Halbleiterschaltkreis nach Anspruch 1, **dadurch gekennzeichnet,** daß das Halbleiterschaltkreiselement (11) aus einem P-Typ Siliciumsubstrat (111) besteht und daß einer der Stützstreifen (14) als eines der beiden Masseanschlußteile dient.

3. Halbleiterschaltkreis nach Anspruch 1 oder 2, **dadurch gekennzeichnet,** daß zwei Stromversorgungsanschlußklemmen (2s, 2z; 2s, 2y) vorgesehen sind, eine für das Schaltkreissystem mit kleinen Signalen und die andere für das System mit Transient-Strömen großer Amplitude.

4. Halbleiterschaltkreis nach Anspruch 3, **dadurch gekennzeichnet,** daß zwei Stromversorgungsanschlußteile (16s, 14) vorgesehen sind, jeweils eines für die beiden Stromversorgungsanschlußklemmen (2s, 2z; 2s, 2y).

## Revendications

1. Dispositif à circuit semi-conducteur qui comporte dans un boîtier (7):
– un élément de circuit semi-conducteur (11) présentant une pluralité de bornes (2a... 2z);
– un élément de montage (13) fait en une fine plaque d'un matériau conducteur sur lequel le dit élément de circuit semi-conducteur est monté;
– une paire de barres de support (14, 15) s'étendant depuis le dit élément de montage; et
– une pluralité d'éléments conducteurs (6a... 6y, 16) à connecter avec la dite pluralité de borne par des fils fins conducteurs (W),
caractérisé en ce que
– le dit élément de circuit semi-conducteur comporte un système de circuit à petit signal et un système de circuit à courant transitoire de forte amplitude avec une borne de masse séparée (2g, 2x) pour chacun des dits deux systèmes, et
– deux éléments conducteurs de masse (6x, 6y ; 14, 16 ; 16g, 16x) sont disposés, un pour chacune des dites deux bornes de masse, dont deux éléments conducteurs présentent une partie de base commune (16c, 18) à leurs extrêmités opposées à l'élément de circuit semi-conducteur, la dite partie de base étant aussi courte que possible.

2. Dispositif selon la revendication 1, caractérisé en ce que le dit élément de circuit semi-conducteur (11) est fabriqué à l'aide d'un substrat en silicium de type P (111) et l'une des dites barres de support (14) est utilisée comme l'un des dits deux éléments de conducteur de masse.

3. Dispositif selon la revendication 1 ou la revendication 2, caractérisé en ce que deux bornes d'alimentation (2s, 2z ; 2s, 2y) sont prévues, une seule pour le dit système de circuit à petit signal et l'autre pour le dit système de circuit à courant transitoire de grande amplitude.

4. Dispositif selon la revendication 3, caractérisé en ce que deux éléments conducteurs d'alimentation (16s, 14) sont prévus, un pour chacune des dites deux bornes d'alimentation (2s, 2z ; 2s, 2y).

FIG. 1

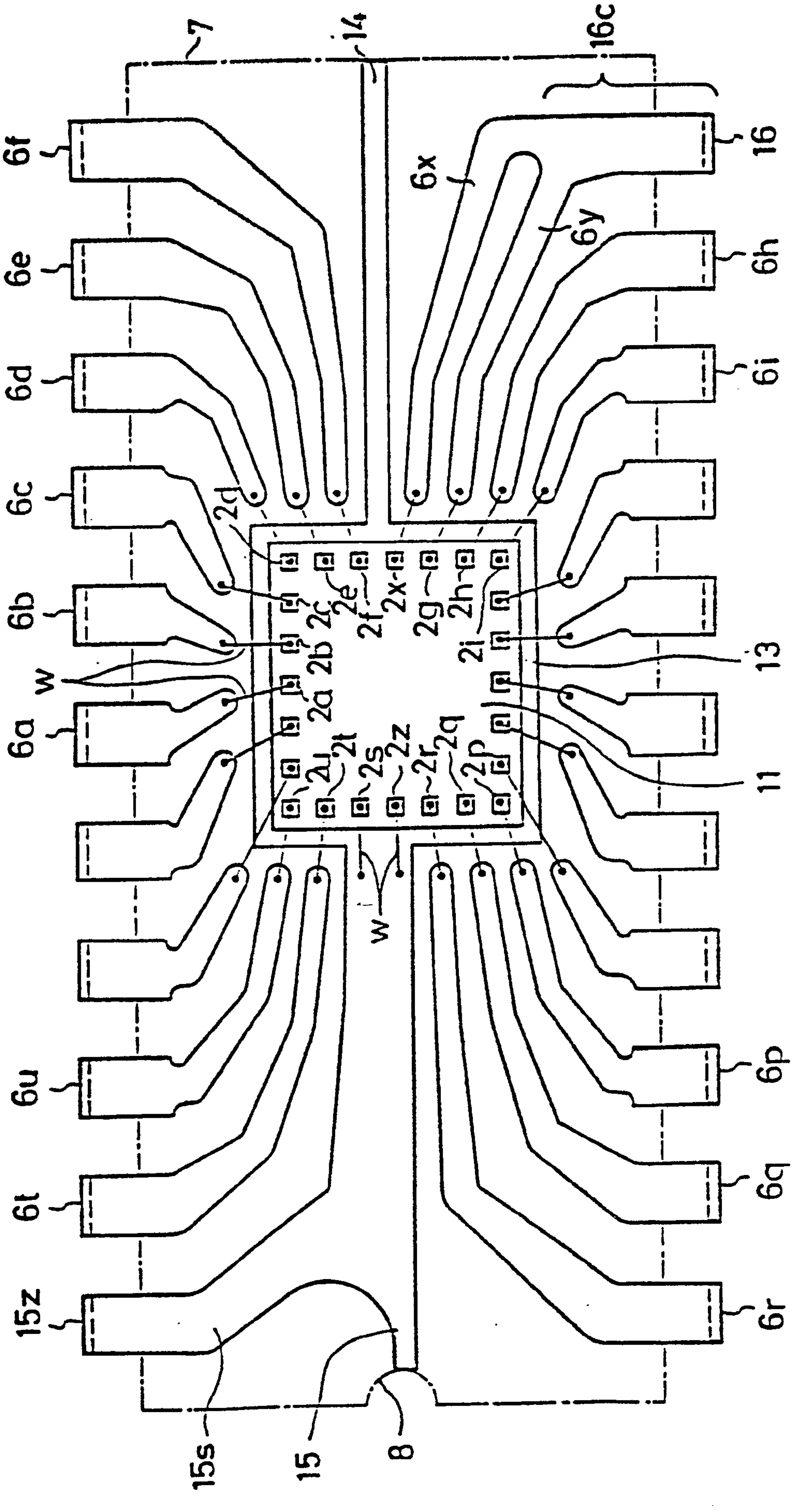
7
14
16c
16
6f
6e
6d
6c
6b
6a
6x
6y
6h
6i
w
2d
2c
2e
2b
2f
2x
2g
2h
2i
2a
2t
2u
2s
2z
2r
2q
2p
13
11
w
6u
6t
15z
6p
6q
6r
15s
15
8

FIG. 2

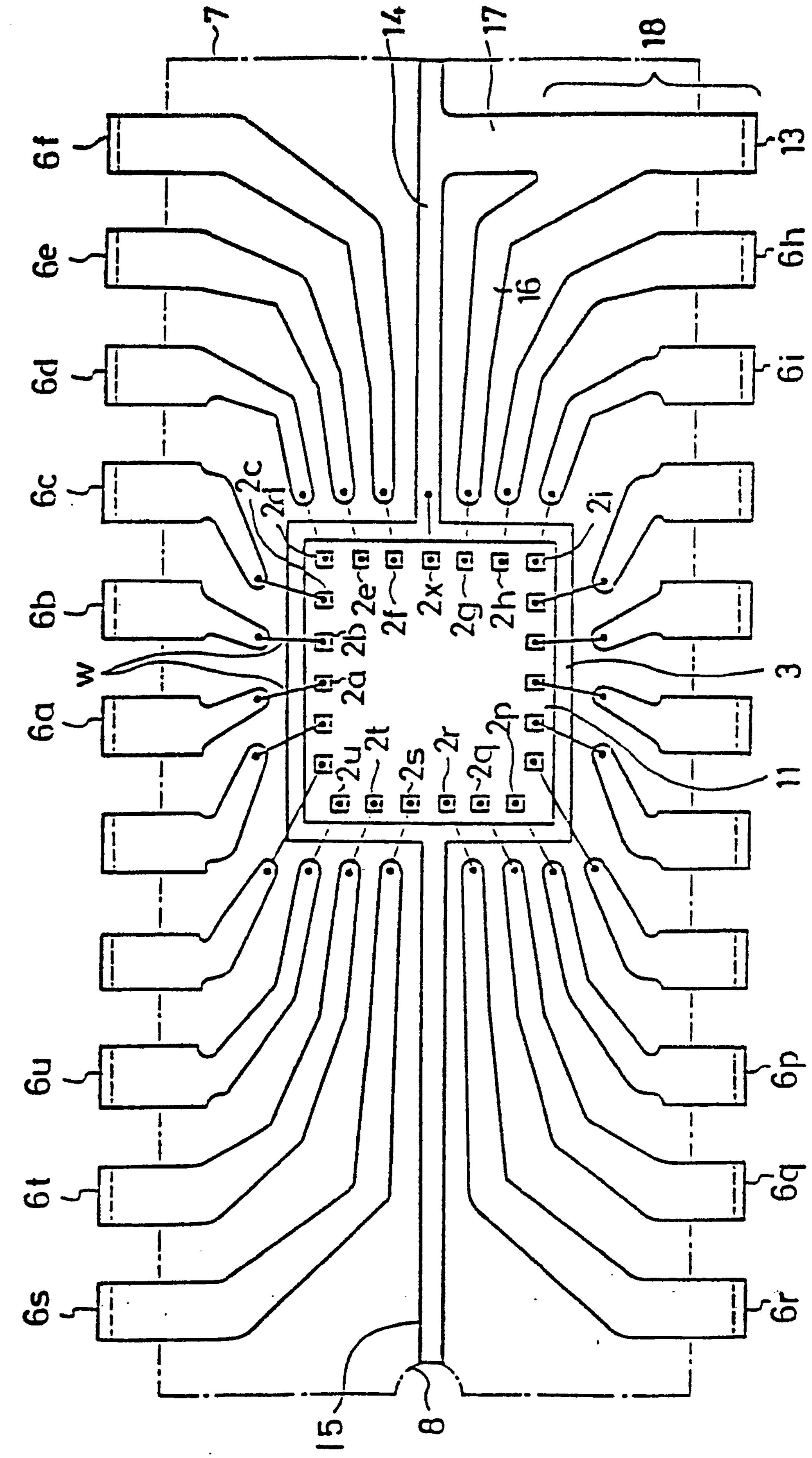
7
14
17
18
13
6f
6e
6d
6c
6b
6a
6u
6t
6s
6h
6i
6p
6q
6r
16
3
11
w
15
8
2a
2b
2c
2d
2e
2f
2x
2g
2h
2i
2p
2q
2r
2s
2t
2u

FIG. 3

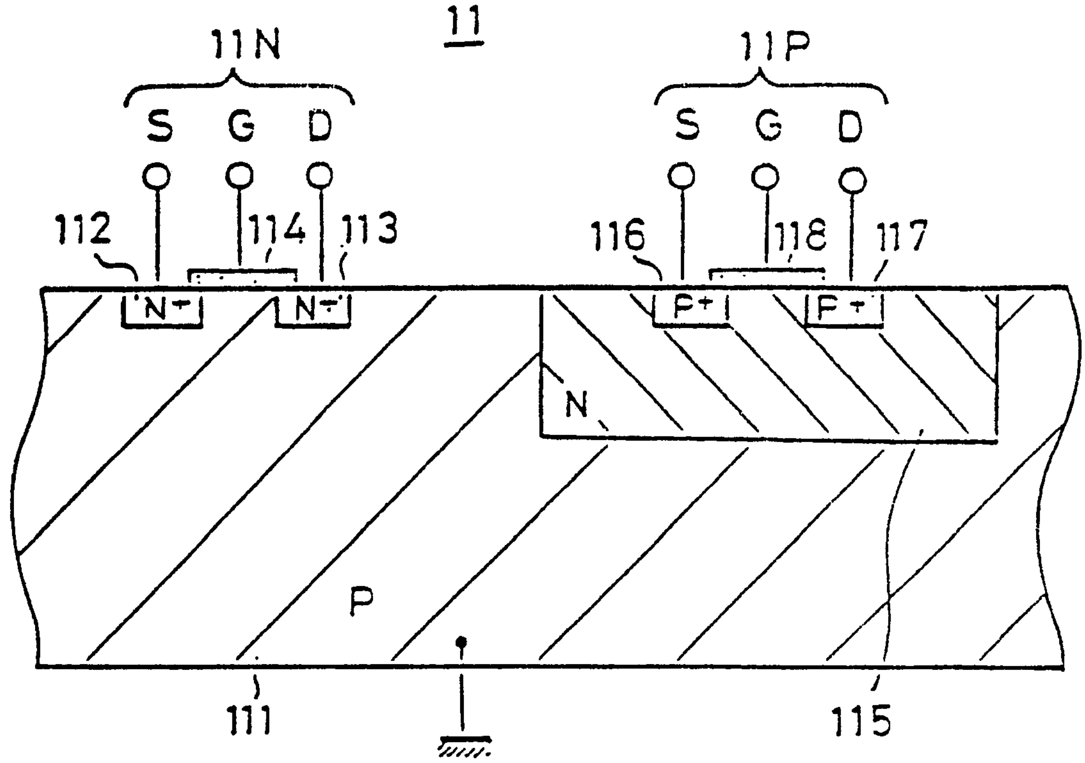
11
11N
S G D
112
114
113
N+
N+
11P
S G D
116
118
117
P+
P+
N
P
111
115

FIG. 6

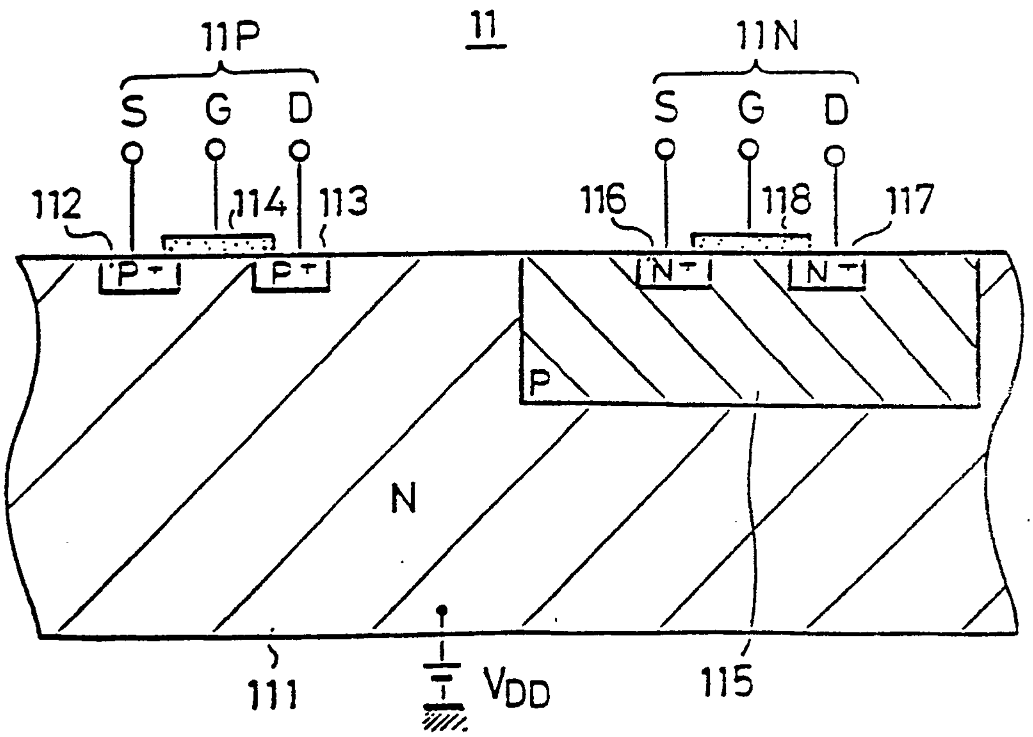
11
11P
S G D
112
114
113
P+
P+
11N
S G D
116
118
117
N+
N+
P
N
111
VDD
115

FIG. 4

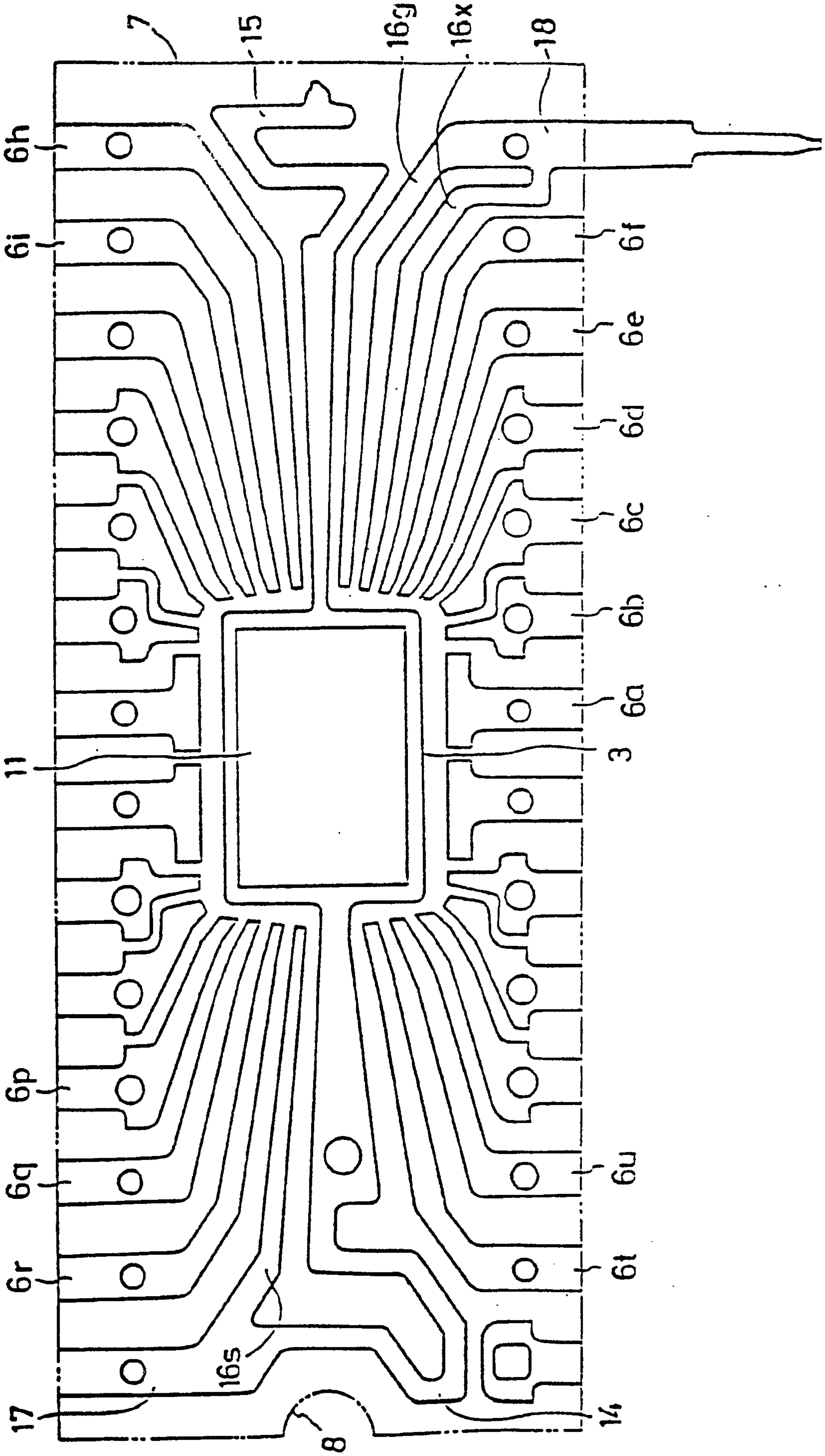

FIG. 5

main portion of one embodiment

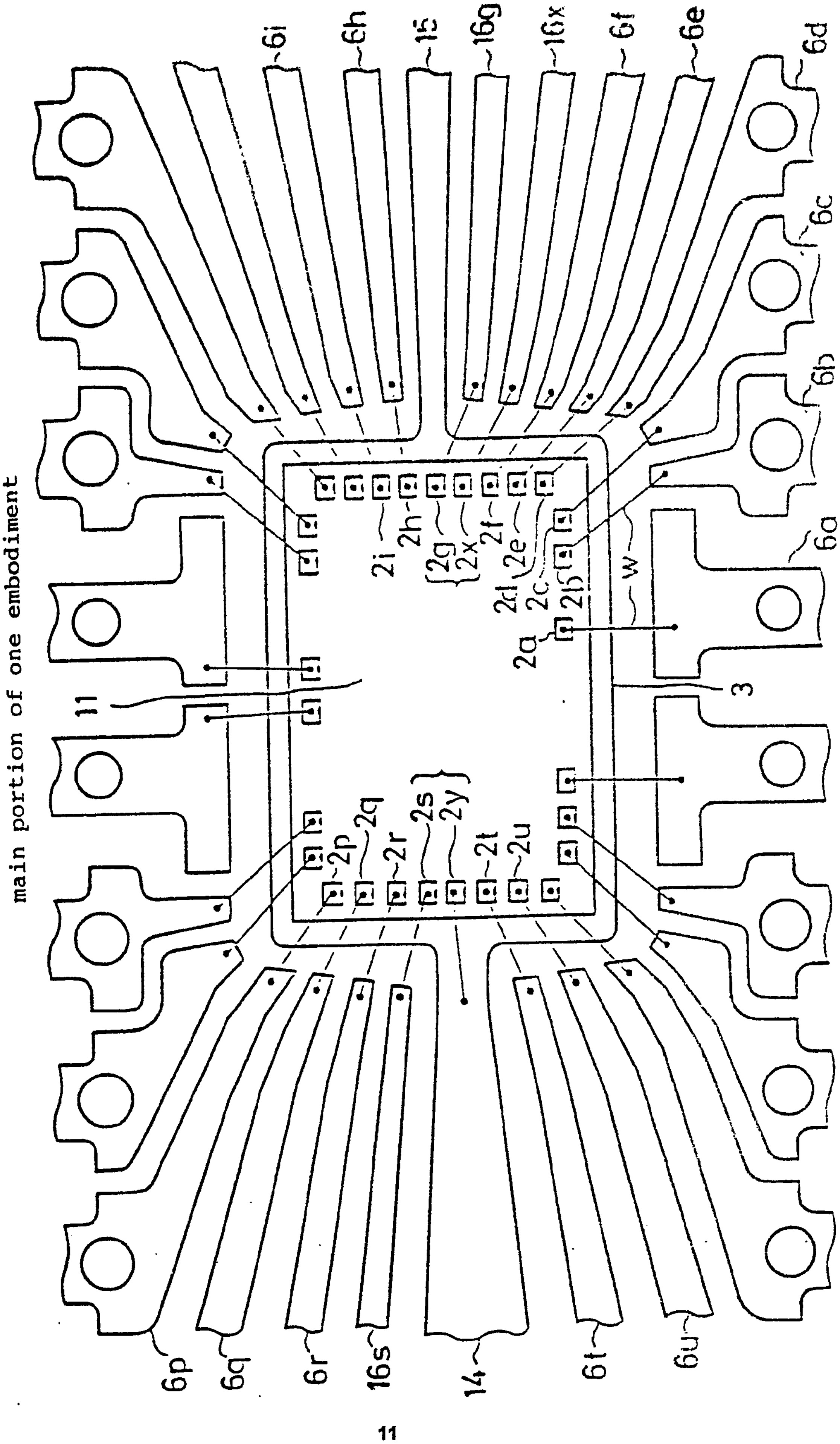

FIG. 7

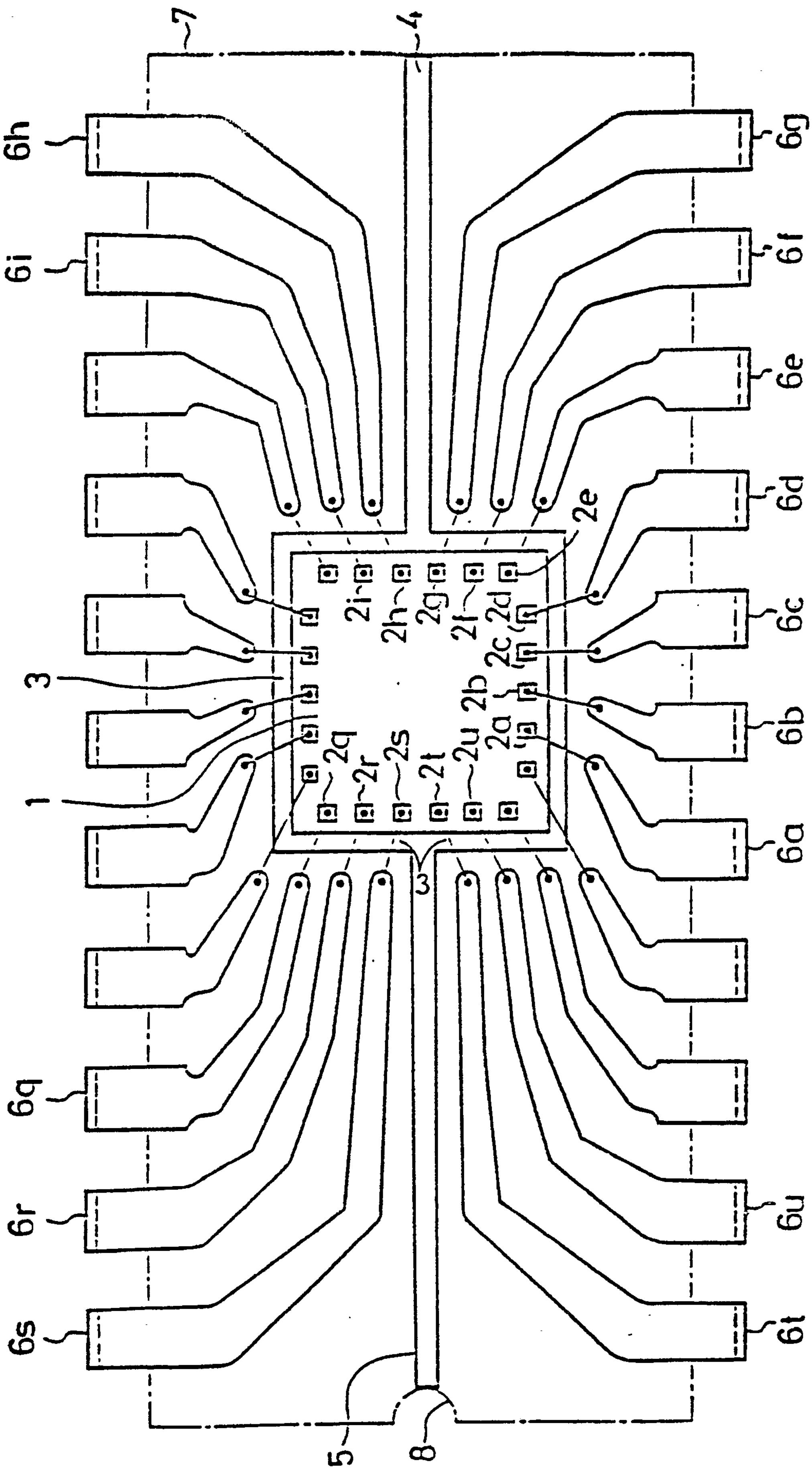
7
4
6h
6i
6g
6f
6e
6d
6c
6b
6a
2e
2d
2c
2b
2a
2f
2g
2h
2i
2q
2r
2s
2t
2u
3
1
3
6q
6r
6s
6u
6t
5
8